# FASCICULE DE BREVET EUROPEEN

(11) **EP 3 918 640 B1**
(45) Date de publication et mention de la délivrance du brevet: **08.11.2023**
(21) Numéro de dépôt: 20721097.2
(22) Date de dépôt: 28.01.2020
(51) Int. Cl.: H01L 31/0352, H01L 31/042, H02S 20/00

(54) **APPAREIL ÉQUIPÉ DE CELLULES PHOTOVOLTAÏQUES DE TYPE SILICIUM CRISTALLIN PRÉSENTANT DES SURFACES DE GÉOMÉTRIES VARIÉES**
VORRICHTUNG MIT KRISTALLINEN SILIZIUM-PHOTOVOLTAIKZELLEN MIT OBERFLÄCHEN MIT UNTERSCHIEDLICHEN GEOMETRIEN
DEVICE EQUIPPED WITH CRYSTALLINE SILICON PHOTOVOLTAIC CELLS HAVING SURFACES WITH VARIED GEOMETRIES

(30) Priorité: 28.01.2019 FR 1900717
(43) Date de publication de la demande: 08.12.2021
(73) Titulaire: Groupe Adeo, 59790 Ronchin (FR)
(72) Inventeur: SAUVAGE, Jeremy, 59910 Bondues (FR); SINAGRA, Baptiste, 59170 Croix (FR)
(74) Mandataire: RVDB
(86) Numéro de dépôt international: PCT/FR2020/000019
(87) Numéro de publication internationale: WO 2020/157400

(56) Documents cités:
- US-A1- 2011 247 672
- US-A1- 2013 112 239
- US-A1- 2015 000 726

## Description

### Domaine technique

La présente invention porte sur un appareil qui comprend des cellules photovoltaïques au silicium cristallin agencées sur une surface plane d'un support. Ces cellules photovoltaïques alimentent, soit directement soit via un accumulateur d'énergie (type batterie, supercondensateur...) rechargé au moyen desdites cellules photovoltaïques, un ou plusieurs composants électriques actifs présents sur ledit appareil, par exemple une ampoule lumineuse, une électrovanne, une pompe, voire d'autres composants ou actionneurs électriques, voire un ou plusieurs équipements électriques qui sont associés audit appareil.

### Etat de la technique

Il est connu de nombreux appareils qui fonctionnent au moyen de cellules photovoltaïques alimentant directement ou indirectement - via un accumulateur d'énergie - les composants électriques actifs dudit appareil. Ces cellules photovoltaïques peuvent consister en des cellules photovoltaïques entières de forme rectangulaire dont les dimensions sont choisies parmi une gamme standard, ou en des portions de cellule photovoltaïque de forme rectangulaire mises en oeuvre à partir de cellules photovoltaïques entières qui sont sectionnées afin de réduire les dimensions de ladite forme rectangulaire. Ainsi, le terme cellule photovoltaïque définit tant une cellule photovoltaïque entière qu'une portion de cellule photovoltaïque entière.

Parmi les applications possibles, figurent tout particulièrement les luminaires extérieurs solaires.

Un luminaire extérieur solaire incorpore une batterie rechargeable qui est rechargée électriquement par des cellules photovoltaïques agencées sur une surface d'un support, par exemple un chapeau ou un couvercle plat agencé sur le dessus du corps dudit luminaire. Le luminaire comprend également une source lumineuse, par exemple une ou plusieurs ampoules halogènes, incandescentes ou à diodes électroluminescentes (ampoules LED), qui est alimentée électriquement par l'accumulateur d'énergie.

Un inconvénient des luminaires extérieurs solaires actuellement sur le marché concerne la capacité de recharge de l'accumulateur d'énergie, laquelle impacte sur l'encombrement de la surface du support recevant les cellules photovoltaïques. En effet, une cellule photovoltaïque a traditionnellement une forme rectangulaire et permet de délivrer une tension de l'ordre de 0,5 Volts, le montage en série de plusieurs cellules photovoltaïques ou portions de cellule photovoltaïque permettant d'augmenter le voltage proportionnellement au voltage de l'accumulateur d'énergie à recharger. Afin de jouer sur l'intensité délivrée qui va impacter sur le temps de recharge de l'accumulateur d'énergie, il convient soit de monter en parallèle plusieurs cellules photovoltaïques ou plusieurs groupes de cellules photovoltaïques montées en série (selon la tension souhaitée) soit d'augmenter la surface des cellules photovoltaïques (entières ou portions). Cela impose donc d'augmenter la surface du support recevant les cellules photovoltaïques, parfois en prévoyant un panneau de support additionnel au corps du luminaire, ce qui impacte fortement sur l'esthétisme du luminaire.

Pour conserver un luminaire solaire avec un support peu encombrant et esthétique, il convient de limiter la capacité de recharge, ce qui joue sur la puissance de la source lumineuse alimentée par l'accumulateur d'énergie voire sur le temps d'utilisation de cette source lumineuse.

La demanderesse a connaissance de la demande de brevet coréen publiée sous le numéro KR20100089855A qui décrit un voilier comprenant des surfaces à géométries variées - notamment celles sur la coque et sur la voile - sur lesquelles sont agencées une multitude de cellules photovoltaïques de sorte à augmenter la captation d'énergie pour produire suffisamment d'électricité pour les besoins de la navigation, voire à réduire la taille de la voile tout en produisant suffisamment d'électricité pour les besoins de la navigation. Les cellules photovoltaïques mises en place sur une surface du voilier présentent toutes une géométrie identique, carrée ou circulaire, de petite surface et sont rapportées directement sur ladite surface ou par l'intermédiaire d'un textile supportant lesdites cellules photovoltaïques.

Il est également connu les demandes de brevet américain publiées sous les numéros US2013112239A1, US2017179321A1 et US2015000726A1 qui jouent sur les géométries et les dimensionnements des cellules photovoltaïques de sorte à exploiter au mieux la surface de support.

La demande de brevet américain US2013112239A1 décrit une surface circulaire qui comprend un anneau intérieur et un anneau extérieur sur chacun desquels sont agencés des cellules photovoltaïques de forme trapézoïdale. Les cellules photovoltaïques sur l'anneau intérieure sont toutes identiques entre elles et elles sont disposées les unes à côtés des autres de manière à couvrir la surface de l'anneau intérieur et à délivrer une intensité identique. Il en est de même avec les cellules photovoltaïques sur l'anneau extérieur, l'aire des cellules photovoltaïques sur l'anneau intérieur étant différente de celle des cellules photovoltaïques sur l'anneau extérieur de sorte que les cellules photovoltaïques génèrent toutes un courant sensiblement identique. Les cellules photovoltaïques de l'anneau intérieur et celles de l'anneau extérieur sont montées en série.

La demande de brevet américain US2017179321A1 divulgue la mise en oeuvre d'un réseau de panneaux solaires agencé sur un chapeau d'un lampadaire, ce chapeau disposant des plusieurs supports sur chacun desquels sont agencées des cellules photovoltaïques montées en série. Ces supports ont des orientations différentes de sorte que lesdites surfaces sont exposées différemment au soleil. Les surfaces de ces supports peuvent avoir des géométries différentes et quelconques, c'est-à-dire qu'elles peuvent être planes, concaves, convexes, voire d'autres formes incurvées ou non-incurvées. Les cellules photovoltaïques agencées sur ces supports sont planes et présentent des formes trapézoïdales ou rectangulaires, les aires de ces cellules photovoltaïques sur chacun de ces supports étant toutes égales de manière à générer un courant sensiblement identique.

La demande de brevet américain US2015000726A1 divulgue la mise en oeuvre d'une structure solaire qui a pour objectif d'augmenter la surface totale occupée par les panneaux solaires sur cette structure. Pour cela, la structure comprend un socle qui présente une ou plusieurs cavités, chaque cavité comprenant plusieurs facettes planes ayant des formes polygonales variées et des orientations variées, la surface totale définie par les facettes étant supérieure à la surface définie par l'ouverture de la cavité. Ces facettes reçoivent chacune un ou plusieurs panneaux solaires. Ces panneaux solaires peuvent être de forme polygonale (triangle, rectangle, carré, trapèze, pentagone, hexagone ...), circulaire ou elliptique, chaque panneau solaire recevant une ou plusieurs cellules photovoltaïques dont la forme peut être rectangulaire, trapézoïdale ou triangulaire, ces cellules photovoltaïques du panneau solaire étant raccordées en série ou en parallèle.

Même si ces antériorités US2013112239A1, US2017179321A1 et US2015000726A1 vise à exploiter au mieux le support recevant les cellules photovoltaïques, les résultats atteints ne sont pas encore optimaux.

### Exposé de l'invention

L'invention vise à pallier ou pour le moins réduire les inconvénients précités. L'invention a pour principal objectif de réduire les dimensions du support en optimisant l'intensité fournie par les cellules photovoltaïques, voire d'augmenter l'intensité fournie par les cellules photovoltaïques sans augmenter les dimensions du support.

A cet effet, l'invention porte sur un appareil tel que défini par l'objet de la revendication 1 comprenant au moins un groupe de cellules photovoltaïques de type silicium cristallin montées en série. En outre, l'appareil comprend un support définissant une surface plane munie d'un bord périphérique dont au moins une partie présente une forme incurvée, les cellules photovoltaïques étant agencées sur cette surface plane. On entend par forme incurvée, par exemple une forme concave, convexe ou ondulée voire tout autre forme courbe. De manière remarquable, les cellules photovoltaïques présentent des géométries variées entre elles de sorte à couvrir la surface plane du support avec au moins l'une desdites cellules qui comprend un bord périphérique dont au moins une partie épouse l'au moins une partie incurvée du bord périphérique de la surface plane du support. En d'autres termes, les cellules photovoltaïques sont de formes et/ou de dimensions variées entre elles sur la surface plane du support de sorte à couvrir celle-ci, au moins une des cellules photovoltaïques ayant au moins une partie de son bord périphérique incurvée qui épouse l'au moins une partie incurvée du bord périphérique de la surface plane ayant une forme libre. Ainsi, chaque cellule photovoltaïque sur la surface plane du support peut avoir une géométrie distincte de celles des autres cellules photovoltaïques, toutes les cellules photovoltaïques juxtaposées couvrant ladite surface plane en épousant le bord périphérique de la surface plane ; mais on peut aussi avoir plusieurs cellules photovoltaïques d'une même géométrie, cette géométrie différant toutefois de celles des autres cellules photovoltaïques. On entend par « couvrir la surface plane de support » le fait que les cellules photovoltaïques couvrent en totalité ou en quasi-totalité la surface plane du support du fait qu'un léger espace périphérique non couvert par les cellules photovoltaïques et attenant au bord périphérique de la surface plane de support peut subsister et que les cellules photovoltaïques sont légèrement espacées entre elles. Par surface plane du support, on entend surface plane utile du support : des vis, capteurs, diodes (...) peuvent aussi contraindre, voir réduire cette surface plane utile, la présente invention permettant aussi l'adaptation de la forme de ces cellules photovoltaïques selon ces contraintes. Bien entendu, les cellules photovoltaïques disposées sur la surface plane sont elles-mêmes planes.

Selon une réalisation préférentielle, l'au moins une partie incurvée sur le bord périphérique de l'au moins une cellule photovoltaïque est constituée d'une courbe continue. On pourrait toutefois envisager une variante prévoyant la mise en oeuvre de cette courbe par une multi-segmentation de ladite au moins une partie du bord périphérique de la cellule photovoltaïque afin de s'approcher au plus proche de la forme incurvée de l'au moins une partie du bord périphérique de la surface plane du support.

Contrairement à l'antérieur où les cellules photovoltaïques se limitent à une forme rectangulaire, triangulaire ou trapézoïdale, les cellules photovoltaïques selon l'invention présentent des formes de géométries variées dont certaines peuvent être polygonales mais dont les autres présentent un bord périphérique avec au moins une partie incurvée ou courbée, par exemple concave, convexe ou ondulée, déterminée en fonction de la forme incurvée de l'au moins une partie du bord périphérique de la surface plane du support de sorte que le ou les groupes de cellules photovoltaïques couvrent ladite surface plane.

Selon l'appareil objet de l'invention, les cellules photovoltaïques présentent chacune des formes et/ou des dimensions déterminées pour que chaque cellule photovoltaïque délivre une même intensité. On entend par « même intensité », la possibilité d'avoir toutes les cellules photovoltaïques qui délivrent une intensité strictement identique mais aussi que les cellules photovoltaïques délivrent des intensités sensiblement identiques, de légères différences étant en effet possibles, fonction de l'hétérogénéité du rendement des cellules photovoltaïques, de la présence de barres métalliques collectrices et d'interconnexion qui peuvent être présentes sur les faces actives des cellules photovoltaïques et non déduites dans le calcul des surfaces actives. Bien entendu, des variantes d'appareils restent envisageables dans le cadre de l'invention en ayant des cellules photovoltaïques qui présentent des écarts de valeurs d'intensités plus importants, l'objectif de l'invention étant toutefois de tendre vers une valeur d'intensité identique pour réduire les pertes de puissance. Dans ce cas, l'intensité de l'au moins un groupe de cellules photovoltaïques montées en série est égale à l'intensité de la plus faible desdites cellules photovoltaïques montées en série.

L'appareil selon l'invention peut être un appareil électrique qui, outre les caractéristiques précitées du support et des cellules photovoltaïques, comprend au moins un composant électrique actif, l'au moins un groupe de cellules photovoltaïques de type silicium cristallin montées en série permettant l'alimentation électrique de l'au moins composant électrique actif soit directement soit indirectement, par l'intermédiaire d'un accumulateur d'énergie du type batterie, supercondensateur ou autre. L'au moins un composant électrique actif peut être, par exemple, une source lumineuse électrique, un moteur électrique, une pompe électrique, un vérin électrique, etc. Cet appareil selon l'invention peut être aussi un panneau solaire qui comporte les caractéristiques essentielles précitées du support et des cellules photovoltaïques et qui soit est rapporté sur un appareil électrique comprenant au moins un composant électrique actif, soit est associé à des équipements électriques et les alimente directement ou par le biais d'accumulateurs d'énergie.

Selon une réalisation de l'appareil objet de l'invention, la surface plane du support a une forme choisie parmi un cercle, une ellipse et un haricot, les cellules photovoltaïques constituant chacune une section de ladite forme. Ces formes ne sont pas limitatives, d'autres formes restant envisageables dans le cadre de l'invention, par exemple une forme en demi-lune ou un secteur. Selon une réalisation, les sections des cellules photovoltaïques sont de largeurs variées et dimensionnées de sorte à délivrer une intensité identique, comme évoqué ci-dessus.

Selon une réalisation de l'appareil objet de l'invention, au moins un trou est mis en oeuvre sur au moins une des cellules photovoltaïques. Cet au moins un trou peut par exemple permettre la réception d'un composant électrique ou être réalisé à but décoratif ou de gestion de la transparence/du passage de la lumière. De tels trous présentent par exemple l'avantage de permettre la réception d'ampoules sur un luminaire éclairant vers le haut, comme cela est le cas sur des luminaires encastrés dans le sol ou sur certaines appliques murales ayant un éclairage indirect. D'autres composants électriques pourraient être placés dans les trous, par exemple des capteurs, selon le type d'appareil mis en oeuvre et la fonction recherchée. De tels trous engendrent des pertes d'intensité, lesquelles sont compensées en augmentant les surfaces des cellules photovoltaïques munies desdits trous de sorte à conserver une intensité identique pour toutes les cellules photovoltaïques ; dans le cas de la réalisation décrite précédemment où les cellules constituent des sections de la surface plane de support, les largeurs des sections des cellules photovoltaïques munies des trous seront augmentées pour compenser lesdites pertes d'intensité.

Selon une réalisation de l'appareil objet de l'invention, celui-ci comprend un seul groupe de cellules photovoltaïques. Dans ce cas, la tension fournie est proportionnelle au nombre de cellules photovoltaïques et l'intensité fournie est égale l'intensité la plus faible délivrée par l'une des cellules photovoltaïques, lesdites cellules photovoltaïques visant à délivrer une intensité identique, comme décrit précédemment.

Selon une autre réalisation de l'appareil objet de l'invention, celui-ci comprend plusieurs groupes de cellules photovoltaïques montés entre eux en parallèle et/ou en série. Dans le cas d'un montage en parallèle de plusieurs groupes de cellules photovoltaïques, la tension fournie est proportionnelle au nombre de cellules photovoltaïques d'un groupe, ledit nombre étant identique pour chaque groupe qui ont le même voltage, et l'intensité fournie est égale à la somme des intensités délivrées par lesdits groupes. Cette mise en oeuvre sera envisagée par exemple pour des appareils plus puissants ou équipés d'accumulateurs d'énergie de plus grosses capacités, par exemple une pompe de relevage, un éclairage urbain de forte puissance, une caméra connectée de surveillance extérieure avec enregistrement en continu, voire encore un véhicule électrique solaire qui présente des surfaces non planes obligeant un fractionnement aléatoire des cellules photovoltaïques pour les conformer à la forme du support. Le cas d'un montage en série de plusieurs groupes de cellules photovoltaïques peut être envisagé par exemple pour des panneaux solaires modulaires permettant de faire fonctionner des moteurs de tensions différentes ou de recharger des batteries de tensions différentes, (12, 24, 36 volts...) selon l'assemblage réalisé par l'utilisateur. Une combinaison des deux montages (parallèle et série) peut également être envisagée.

Selon une réalisation, l'appareil est un luminaire. Selon une réalisation, ce luminaire est conçu pour éclairer vers le haut, ledit luminaire comprenant au moins une lampe disposée dans l'au moins un trou mis en oeuvre sur l'au moins une des cellules photovoltaïques. Cela est le cas pour des luminaires encastrés dans le sol ou pour des luminaires en applique assurant un éclairage indirect, vers le haut. Bien entendu, d'autres luminaires peuvent être mis en oeuvre dans le cadre de l'invention, tels que des bornes, des lanternes ou des appliques conçues pour assurer un éclairage vers le bas ou sur les côtés, dans quel cas la présence de trous sur les cellules photovoltaïques ne sera pas nécessaire.

Selon une autre réalisation, l'appareil est un parasol comprenant un piètement muni d'au moins un montant de support d'une toile et au moins un luminaire agencé pour éclairer sous la toile en position déployée. En outre, un support muni de l'au moins un groupe de cellules photovoltaïques est agencé en partie supérieure du parasol, par exemple en partie supérieure de la toile ou en partie supérieure du ou des montants, de sorte que la toile ne fasse pas d'ombre sur ledit support.

Selon une autre réalisation, l'appareil est un système d'arrosage automatique de pelouse ou jardin qui comprend une électrovanne et un boîtier de commande de l'électrovanne alimenté électriquement par la batterie rechargée au moyen des cellules photovoltaïques.

Selon une autre réalisation, l'appareil est un robot tondeuse qui comprend un support sur lequel est agencé l'au moins un groupe de cellules photovoltaïques. Selon une variante, ce robot tondeuse comprend une base mobile de tonte munie de la batterie et une station de rechargement conçue pour accueillir ladite base mobile en sorte de recharger la batterie. En outre, la station de rechargement comprend un corps muni dudit support comprenant l'au moins un groupe de cellules photovoltaïques. On pourrait aussi prévoir une variante de robot tondeuse pour laquelle les cellules photovoltaïques sont agencées directement sur la partie supérieure de la base mobile de tonte qui sert directement de support comprenant l'au moins un groupe de cellules photovoltaïques.

Selon une autre réalisation, l'appareil est un panneau solaire. Ce panneau solaire pourra être conçu pour être rapporté sur un corps d'un appareil électrique. En variante, ce panneau solaire pourra être conçu pour être rapporté sur une surface de support, par exemple une toiture d'habitation ou un sol, et pour alimenter des équipements électriques externes.

### Brève description des figures

Les caractéristiques et avantages de l'invention apparaîtront à la lecture de la description suivante s'appuyant sur des figures, parmi lesquelles :
[Fig. 1] la figure 1 est une vue d'un support circulaire d'un luminaire selon l'art antérieur avec un agencement des cellules photovoltaïques tel qu'existant jusqu'à présent ;
[Fig. 2] la figure 2 est une vue d'un support circulaire d'un luminaire avec des cellules photovoltaïques de géométries variées, mais formant des sections de largeurs constantes ;
[Fig. 3] la figure 3 est une vue d'un support circulaire d'un luminaire selon l'invention, avec des cellules photovoltaïques de géométries variées et formant des sections de largeurs variées ;
[Fig. 4] la figure 4 est une vue correspondant à la figure 3 et montre la présence de barre métalliques collectrices et de connexion reliant les cellules photovoltaïques, présentes sur le dessus de la surface active des cellules photovoltaïques ;
[Fig. 5] la figure 5 est une vue correspondant à la figure 3, avec la présence de trous sur les cellules photovoltaïques ;
[Fig. 6] la figure 6 est une vue correspondant à la figure 4, avec la présence de trous sur les cellules photovoltaïques ;
[Fig. 7] la figure 7 est une vue d'un support en forme de haricot, avec des cellules photovoltaïques de géométries variées et formant des sections de largeurs variées ;
[Fig. 8] la figure 8 est une vue schématique d'un parasol selon l'invention ;
[Fig. 9] la figure 9 est une vue schématique d'un robot tondeuse selon l'invention ;
[Fig. 10] la figure 10 illustre une partie courbe d'un bord périphérique d'une cellule photovoltaïque mise en oeuvre par une multi-segmentation de ladite cellule.

### Description détaillée de l'invention

Dans la suite de la description, seules les caractéristiques spécifiques à l'invention sont détaillées. Toutes les caractéristiques relatives à la conception des cellules photovoltaïques au silicium cristallin, monocristallin ou polycristallin, sont bien connues de l'homme du métier qui pourra se référer à la littérature existante ; ces caractéristiques ne sont donc pas détaillées ci-après. De même, toutes les caractéristiques relatives à la conception d'un appareil équipé d'une batterie et de cellules photovoltaïques permettant la recharge de cette batterie, la batterie permettant l'alimentation de composants électriques actifs (ampoules, moteurs, électrovannes, actionneurs ...), sont bien connues de l'homme du métier qui pourra se référer à la littérature existante ; ces caractéristiques ne sont donc également pas détaillées ci-après.

Dans la suite de la description, l'appareil selon l'invention sera dénommé « luminaire », « parasol » et « robot tondeuse », celui-ci pouvant toutefois prendre d'autres formes dès l'instant où il présente les caractéristiques propres à l'invention.

Dans la suite de la description, les cellules photovoltaïques au silicium cristallin sont dénommées « cellules photovoltaïques ».

Dans la suite de la description, les mêmes références sont utilisées pour désigner les mêmes caractéristiques ou leurs équivalents, sauf indication contraire.

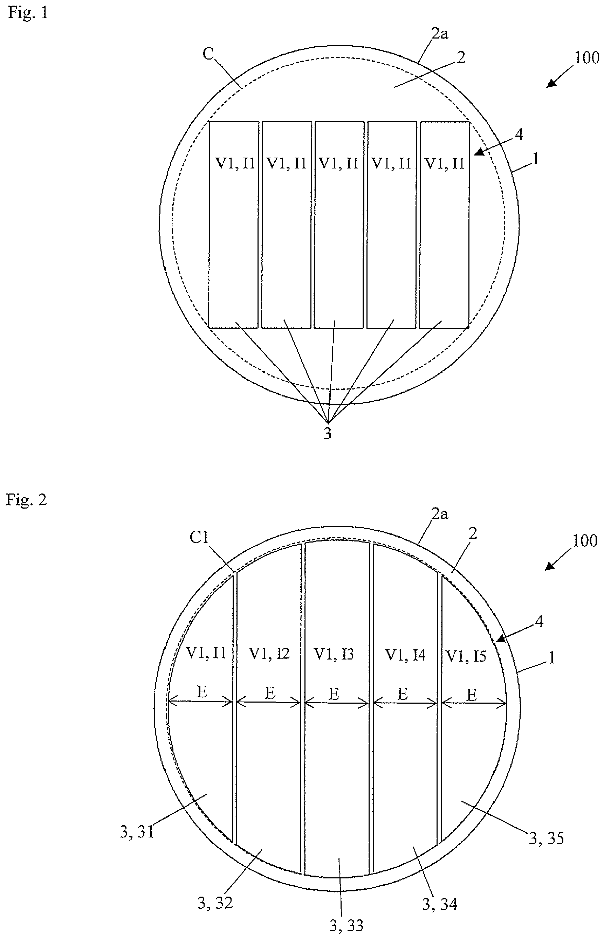

La figure 1 montre un support 1 d'un luminaire100 selon l'art antérieur, ce support 1 définissant une surface plane 2 de forme circulaire. Sur ce support 1 sont agencées des cellules photovoltaïques 3 qui sont toutes de formes rectangulaires et de dimensions identiques, ces cellules photovoltaïques 3 étant inscrites dans un cercle C, comme l'illustre cette figure 1. Ces cellules photovoltaïques 3 sont montées en série et forment un groupe de cellules photovoltaïques 4. Les cellules photovoltaïques 3 délivrent toutes une tension V1 de 0,5 Volts et une intensité I1 identique, ce qui permet auxdites cellules photovoltaïques montées en série de délivrer finalement une tension V égale à 2,5 Volts (cinq cellules photovoltaïques 3 de 0,5 Volts étant illustrées sur la figure 1) et une intensité I égale à I1. L'intensité I1 dépend de la surface S1 de chaque cellule photovoltaïque 3. On constate en regard de la figure 1, que les dimensions de la forme rectangulaire des cellules photovoltaïques 3 sont limitées par le diamètre du support 1. Ainsi, pour augmenter l'intensité I fournie par le groupe de cellules photovoltaïques 4, il est nécessaire d'augmenter le diamètre du support 1. Une autre possibilité est de prévoir plusieurs groupes de cellules photovoltaïques 4 montés en parallèle, ce qui nécessite d'augmenter également le diamètre du support 1 et complexifie les connexions électriques entre les cellules photovoltaïques 3.

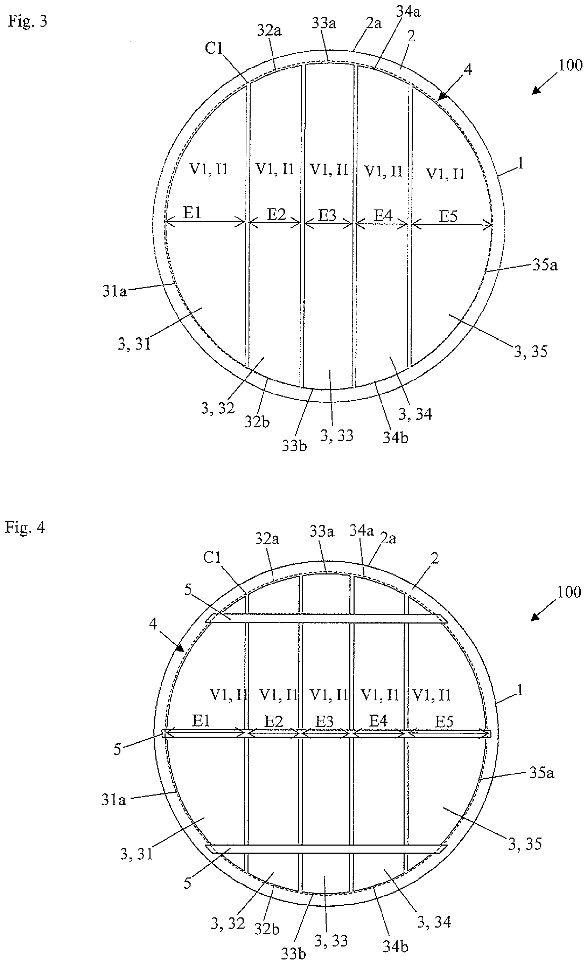

Sur les figures 2 à 7, le luminaire 100 pallie les inconvénients précités pour la figure 1 et offre en outre la possibilité de modifier plus facilement les formes du support 1, ce qui permet de jouer sur le design du luminaire 100 mis en oeuvre et/ou de prévoir un luminaire 100 plus compact. Pour cela, les cellules photovoltaïques 3 montées en série présentent des géométries variées, ce qui permet d'augmenter l'intensité fournie par chaque cellule photovoltaïque 3 ou d'augmenter la tension fournie en augmentant le nombre de cellules photovoltaïques 3 sur le groupe de cellules photovoltaïques 4, selon les besoins de l'accumulateur d'énergie (non illustrée) du luminaire 100, sans nécessité une augmentation de la surface plane 2 du support 1. La figure 2 n'est qu'une étape intermédiaire entre l'art antérieur illustré en figure 1 et l'invention illustrée en figures 3 à 8.

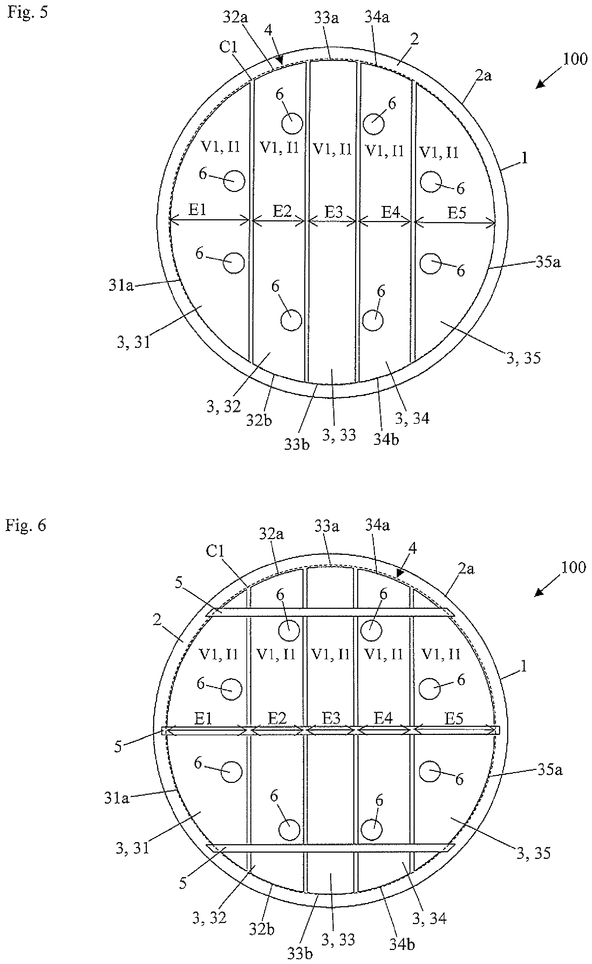

Sur les figures 2 à 6, le support 1 est de forme circulaire, comme sur la figure 1. Cinq cellules photovoltaïques 3 sont prévues et montées en série, celles-ci délivrant toutes une tension V1 de 0,5 Volts, ce qui permet au groupe de cellules photovoltaïques 4 de fournir une tension V de 2,5 Volts. Sur ces figures 2 à 6, les cellules 3 forment chacune une section 31 à 35 d'un cercle C1 dont le diamètre est très légèrement inférieur au diamètre du support 1. Sur ces figures 2 à 6, les cellules 31, 35 aux extrémités présentent chacune un bord périphérique ayant une partie arquée 31a, 35a et les cellules 32, 33, 34 intermédiaires présentent chacun un bord périphérique ayant deux parties arquées 32a-32b, 33a-33b, 34a-34b. Ces parties arquées 31a, 32a-32b, 33a-33b, 34a-34b, 35a des cellules 31 à 35 définissent un cercle C1 qui épouse le bord circulaire 2a de la surface plane 2 du support 1, seul un léger espacement périphérique 7 demeurant non couvert par les cellules 31 à 35 sur la surface plane 2, cet espacement 7 pouvant être réduit au minimum voire supprimé. Sur la figure 2, les cinq sections 31 à 35 ont une largeur E identique, ce qui permet aux cinq cellules photovoltaïques de fournir cinq intensités I1 à I5 de différentes valeurs entre elles, avec toutefois l'intensité I1 égale à l'intensité I5 et l'intensité I2 égale à l'intensité I4. Sur les figures 3 à 6, les cinq sections 31 à 35 ont des largeurs E1 à E5 variées et déterminées permettant aux cinq cellules photovoltaïques 3 de fournir une intensité I1 identique ou quasi identique. Sur la figure 4, la présence de trois barres métalliques 5 en surface des cellules photovoltaïques 3, permettant d'assurer leur connexion en série, a pour incidence de réduire légèrement l'intensité I1 délivrée par chacune de ces cellules photovoltaïque 3 dont les largeurs E1 à E5 des sections 31 à 35 sont adaptées pour avoir la même intensité I1. Sur la figure 5, des trous 6 sont pratiqués dans certaines des cellules photovoltaïques 3, à savoir sur les sections 31, 32, 34 et 35, les largeurs E1 à E5 des cinq sections 31 à 35 étant adaptées pour conserver une intensité I1 identique pour toutes les cellules photovoltaïques 3. Ces trous 6 réduisent légèrement les intensités délivrées par les cellules photovoltaïques 3. On peut prévoir une répartition différente des trous 6 sur les sections 31 à 35, dans quel cas on adaptera les largeurs E1 à E5 pour conserver une intensité I1 identique pour toutes les cellules photovoltaïques 3. De tels trous 6 permettent d'y loger des ampoules lumineuses (non illustrées), par exemple pour un luminaire 100 encastré dans le sol ou pour un luminaire monté en applique mural et assurant un éclairage indirect vers le haut. Sur la figure 6 qui est une combinaison des figures 4 et 5, des barres métalliques 5 et des trous 6 sont présents, les largeurs E1 à E5 étant adaptées pour conserver une intensité I1 identique pour toutes les cellules photovoltaïques 3. Bien entendu, on peut prévoir des barres métalliques 5 et/ou des trous 6 sur les cellules photovoltaïques 3 de la figure 2 pour laquelle les sections 31 à 35 ont une largeur E identique, les intensités I1 à I5 étant dans ce cas différentes.

A titre comparatif, en considérant des cellules photovoltaïques 3 ayant un rendement de 17%, soit 0,5 V et 340 A/m² :
- sur la figure 1, les cinq cellules photovoltaïques 3 inscrites dans un cercle C de diamètre de 125 mm délivrent chacune une intensité I1 de 0,515 Ampères :
- sur la figure 2, les cinq cellules photovoltaïques 3 inscrites dans un cercle C1 de diamètre de 125 mm et présentant une largeur E constante permettent de délivrer une intensité I1 (égale à I5) de 0,586 Ampères, une intensité I2 (égale à I4) de 0,970 Ampères et une intensité I3 de 1,064 Ampères, l'intensité fournie par le groupe de cellules photovoltaïques étant par conséquent de 0,586 Ampères, supérieur au cas de la figure 1 ;
- sur la figure 3, les cinq cellules photovoltaïques 3 inscrites dans un cercle C1 de 125 mm et présentant des largeurs E1 à E5 variées permettent de délivrer une intensité I1 de 0,833 Ampères identique pour chaque cellule photovoltaïque 3, bien supérieur au cas de la figure 1. Afin d'obtenir une intensité I1 de 0,833 Ampères dans le cas de la figure 1, il conviendrait d'augmenter le diamètre du cercle C à une valeur de 156,8 mm, bien supérieur au diamètre du cercle C1 dans le cas de la figure 3.

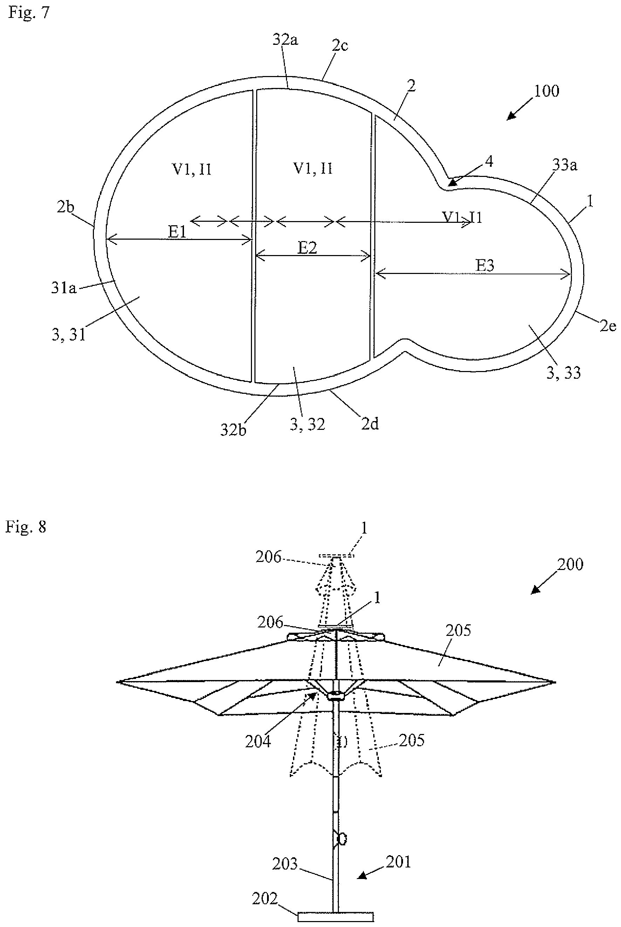

L'avantage de mettre en oeuvre des cellules photovoltaïques 3 à géométries variées est également de pouvoir les adapter sur des supports 1 de formes diverses avec des bords incurvés ou courbés. A titre, d'exemple, sur la variante de la figure 8, le luminaire 100 présente un support 1 dont la surface plane 2 présente une forme de haricot sur laquelle sont agencées trois cellules photovoltaïques 3 constituant trois sections 31 à 33 du haricot ayant des largeurs E1 à E3 variées qui permettent de délivrer une intensité I1 identique. La première cellule 31 a une partie de son bord périphérique 31a qui épouse une partie du bord périphérique 2b de la surface plane 2 du support 1 ; la seconde cellule 32 a deux parties de son bord périphérique 32a, 32b qui épousent respectivement deux parties du bord périphérique 2c, 2d de la surface plane 2 du support 1 ; la troisième cellule 33 a une partie de son bord périphérique 33a qui épouse une partie du bord périphérique 2e de la surface plane 2 du support 1. Seul un léger espacement périphérique 7 demeure non couvert par les cellules 31 à 33 sur la surface plane 2, cet espacement 7 pouvant être réduit au minimum voire supprimé. On pourrait prévoir d'autres variantes, par exemple un support 1 présentant une surface plane 2 dont le bord périphérique présente des parties rectilignes et des parties incurvées, certaines des cellules 3 pouvant avoir un bord périphérique de forme polygonale (triangle, rectangle, trapèze ...) et d'autres des cellules 3 pouvant avoir un bord périphérique avec une ou plusieurs parties incurvées.

Selon l'invention, les cellules photovoltaïques 3 à géométries variées seront de préférence mises en oeuvre par un procédé de découpe laser sur une machine de découpe au laser présentant au moins deux axes de déplacement. Les formes et dimensions des cellules photovoltaïques 3 sur la surface plane 2 du support pourront être déterminées au moyen d'un logiciel de calcul adapté qui détermine les géométries des cellules photovoltaïques 3 en fonction de leur nombre et de la géométrie de la surface plane 2 du support 1, afin d'optimiser l'intensité délivré par le groupe de cellules photovoltaïques 4.

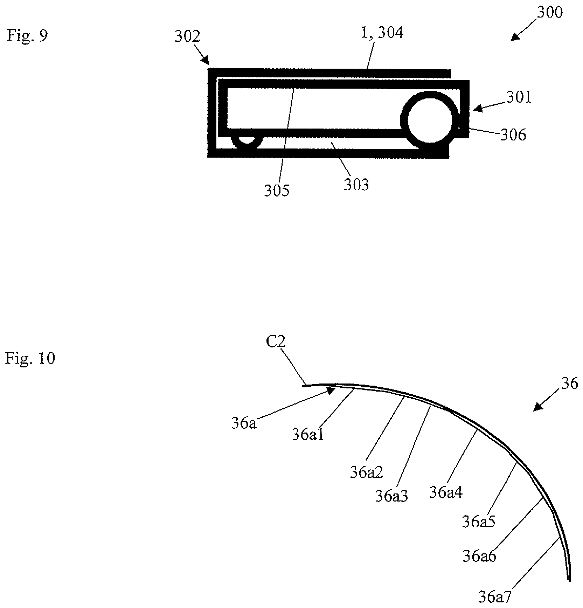

Les exemples décrits précédemment à l'appui des figures 1 à 7 font références à un luminaire 100. L'invention peut toutefois être mise en oeuvre sur d'autres types d'appareil. A titre d'exemple, sur la figure 8, l'appareil est un parasol 200 qui comprend un piètement 201 muni d'un socle 202 et d'un montant 203 sur lequel est agencé un système de déploiement 204 d'une toile souple 205, cette conception de parasol 200 étant bien connue. A l'extrémité supérieure 206 de la toile 205 est prévu le support 1 sur la surface plane 2 duquel sont agencées les cellules photovoltaïques 3 à géométries variées (seul le support 1 apparaît sur la figure 9), de manière comparable à celle décrite précédemment pour le luminaire 100 selon les variantes des figures 2 à 7, voire pour d'autres variantes envisageables dans le cadre de l'invention. On peut prévoir de variante de parasol 200, par exemple avec un mât et un bras déporté qui supporte la toile souple (variante non illustrée), voire une tonnelle sur un ou plusieurs montants de laquelle sont prévu des supports 1 (variante non illustrée). Le parasol 200 comprend en outre des luminaires (non illustrées) qui sont disposés sous la toile 205 et fixés par exemple au système de déploiement 204, ces luminaires étant alimentés par l'accumulateur d'énergie (non illustré) qui se recharge grâce aux cellules photovoltaïques 3 sur le support 1.

Selon un autre exemple illustré en figure 9, l'appareil est un robot tondeuse 300 qui comprend une base mobile de tonte 301 et une station de rechargement 302, des moyens de connexion amovible (non illustrés) étant prévus entre la base mobile de tonte 301 et la station de rechargement 302, comme cela est déjà connu. Selon l'invention, la station de rechargement 302 comprend une zone de réception 303 comportant un toit 304 constituant un support 1 sur la surface plane 2 duquel sont agencées les cellules photovoltaïques 3 à géométries variées (seul le support 1 apparaît sur la figure 10). On peut envisager une variante de robot tondeuse 300 sans station de rechargement 302, dans quel cas la partie supérieure 305 du corps 306 de la base mobile de tonte 301 constituera ledit support 1 muni de la surface plane 2.

D'autres variantes sont envisageables dans le cadre de l'invention. Sur les figures 1 à 7, un seul groupe de cellules photovoltaïques 4 est prévu ; le nombre de cellules photovoltaïques 3 du groupe de cellules photovoltaïques 4 pourra varier selon le voltage nécessaire afin de recharger convenablement la batterie (non illustrée). Le nombre de groupes de cellules photovoltaïques 4 pourra également varier selon l'intensité nécessaire afin de recharger convenablement l'accumulateur d'énergie, ces groupes de cellules photovoltaïques 4 étant raccordés en parallèle entre eux.

Sur les figures 2 à 7, les parties incurvées 31a, 32a-32b, 33a-33b, 34a-34b, 35a des cellules 31 à 35 sont des courbes continues. Comme l'illustre la figure 10, on pourrait toutefois envisager qu'une partie incurvée 36a du cellule 36 soit mise en oeuvre par une multitude de petits segments 36a1 à 36a7 visant à s'approcher au plus juste d'une courbe continue C2. Bien qu'une telle multi-segmentation permette de se rapprocher d'une courbe continue, une courbe continue sera privilégiée puisqu'elle permet de réduire l'effet de point chaud dans les angles de raccordement entre les segments 36a1 à 36a7, ce qui pourrait engendrer une perte de rendement et réduire la durée de vie de l'ensemble 100 du fait des variations de température localisées et concentrées qui, selon les process et matériaux utilisés, peuvent entre autre engendrer une altération de l'encapsulage, engendrer un dégazage avec un effet de bulles, marquer et opacifier la surface active. Dans tous les cas, qu'il s'agisse d'une courbe continue ou d'une courbe mise en oeuvre à partir d'une multi-segmentation de la cellule 3, cette courbe doit être réalisée de manière à ne jamais rompre la continuité entre les barres collectrices et les bus-bars présents traditionnellement sur le groupe de cellules 4, faute de quoi le rendement en serait diminué et un effet de zone chaude pourrait apparaître.

Il est précédemment fait référence à des luminaires 100, des parasols 200 et des robots tondeuses 300 ; d'autres appareil sont envisageables, par exemple un système d'arrosage automatique de pelouse ou jardin (non illustré), lequel comprend une électrovanne et un boîtier de commande de l' électrovanne alimenté électriquement par un accumulateur d'énergie. L'accumulateur d'énergie sera rechargé au moyen des cellules photovoltaïques qui sont agencées sur un support 1 mis en oeuvre, par exemple, sur un caisson du boîtier de commande ou sur une platine constituant un chapeau au-dessus du corps de l'électrovanne qui est encastré dans le sol, ledit chapeau étant disposé à fleure du sol.

La description qui précède fait référence à des cellules photovoltaïques 3 délivrant chacune une tension de fonctionnement de 0,5 Volt. Cette valeur de tension de fonctionnement n'est toutefois pas figée, d'autres valeurs de tension de fonctionnement pouvant être envisagées, sans sortir du cadre de l'invention.

Il apparaît à la lecture de la description qui précède que les caractéristiques essentielles de l'appareil objet de l'invention concernent le support 1 qui peut avoir une surface plane 2 avec un bord périphérique à géométrie libre, c'est-à-dire avec au moins une partie dudit bord périphérique présentant une forme incurvée, et les cellules photovoltaïques 3 qui sont à géométrie variées entre elles de sorte à couvrir toute la surface plane 2 dudit support 1 en épousant ledit bord périphérique, tout en visant à atteindre une intensité I1 identique pour toutes les cellules photovoltaïques 3. Ainsi, dans le cadre de l'invention, il est possible de concevoir individuellement un panneau solaire comportant un tel support 1 et de telles cellules photovoltaïques 3 recouvrant la surface plane 2 dudit support 1, un tel panneau solaire pouvant être rapporté sur un appareil électrique ; la forme du support du panneau solaire sera alors éventuellement adaptée à celle du corps de l'appareil électrique qui recevra ledit panneau solaire. A titre d'exemple, le panneau solaire pourrait comporter un support 1 et des cellules photovoltaïques 3 comparables à ceux des figures 2 à 7, le panneau solaire étant alors rapporté sur le dessus du corps du luminaire 100. Un tel panneau solaire pourrait convenir également pour une toiture d'habitation de forme particulière, le panneau solaire alimentant électriquement un ou plusieurs équipements électriques de l'habitation, soit par une alimentation directe -lors de la présence de soleil uniquement - soit par l'intermédiaire d'accumulateurs d'énergie stockant provisoirement l'énergie électrique pour la restituer lorsque cela est nécessaire.

## Revendications

1. Appareil (100, 200, 300) comprenant au moins un groupe de cellules photovoltaïques (4) de type silicium cristallin montées en série et un support (1) définissant une surface plane (2) munie d'un bord périphérique dont au moins une partie (2a, 2b, 2c, 2d, 2e) présente une forme incurvée de façon à définir une forme au moins en partie incurvée pour la surface plane du support, les cellules photovoltaïques (3) étant agencées sur cette surface plane (2), lesdites cellules (31, 32, 33, 34, 35) comprenant un bord périphérique dont au moins une partie (31a, 32a, 32b, 33a, 33b, 34a, 34b, 35a) épouse l'au moins une partie incurvée (2a, 2b, 2c, 2d, 2e) du bord périphérique de ladite surface plane (2), **caractérisé en ce que** les cellules photovoltaïques (3) présentent des géométries variées entre elles et constituent chacune une section (31-35) respective de la forme au moins en partie incurvée de la surface plane (2) de sorte à couvrir ladite surface plane (2), les sections (31-35) étant de largeurs (E1-E5) variées entre elles de sorte à délivrer une intensité (I1) identique.

2. Appareil (100, 200, 300) selon la revendication 1, dans lequel la surface plane (2) du support (1) a une forme choisie parmi un cercle, une ellipse, un haricot, une demi-lune ou un secteur.

3. Appareil (100, 200, 300) selon l'une quelconque des revendications 1 ou 2, dans lequel au moins un trou (6) de réception d'un composant électrique est mis en oeuvre sur au moins une des cellules photovoltaïques (3).

4. Appareil (100, 200, 300) selon l'une quelconque des revendications 1 à 3, lequel comprend un seul groupe de cellules photovoltaïques (4).

5. Appareil (100, 200, 300) selon l'une quelconque des revendications 1 à 3, lequel comprend plusieurs groupes de cellules photovoltaïques (4) montés entre eux en parallèle et/ou en série.

6. Appareil (100) selon l'une quelconque des revendications 1 à 5, lequel est un luminaire.

7. Appareil (100) selon la revendication 6 rattachée à la revendication 3, dans lequel le luminaire est conçu pour éclairer vers le haut, ledit luminaire comprenant au moins une lampe disposée dans l'au moins un trou (6) mis en oeuvre sur l'au moins une des cellules photovoltaïques (3).

8. Appareil (200) selon l'une quelconque des revendications 1 à 7, lequel est un parasol comprenant un piètement (201) muni d'au moins un montant (203) de support d'une toile (204) et au moins un luminaire agencé pour éclairer sous la toile en position déployée, un support (1) muni de l'au moins un groupe de cellules photovoltaïques (4) étant agencé en partie supérieure du parasol.

9. Appareil selon l'une quelconque des revendications 1 à 5, lequel est un système d'arrosage automatique de pelouse ou jardin qui comprend une électrovanne et un boîtier de commande de l'électrovanne alimenté électriquement par un accumulateur d'énergie rechargé au moyen des cellules photovoltaïques (3).

10. Appareil (300) selon l'une quelconque des revendications 1 à 5, lequel est un robot tondeuse qui comprend un support (1) sur lequel est agencé l'au moins un groupe de cellules photovoltaïques (4).

11. Appareil selon l'une quelconque des revendications 1 à 5, lequel est un panneau solaire.

## Patentansprüche

1. Vorrichtung (100, 200, 300), mindestens eine Gruppe von Photovoltaikzellen (4) vom kristallinen Siliziumtyp umfassend, die in Reihe geschaltet sind, und einen Träger (1), der eine flache Oberfläche (2) definiert, die mit einer peripheren Kante ausgestattet ist, von der mindestens ein Teil (2a, 2b, 2c, 2d, 2e) eine so gekrümmte Form aufweist, dass eine mindestens teilweise gekrümmte Form für die flache Oberfläche des Trägers definiert wird, wobei die Photovoltaikzellen (3) auf dieser flachen Oberfläche (2) angeordnet sind, wobei die Zellen (31, 32, 33, 34, 35) eine periphere Kante umfassen, von der mindestens ein Teil (31a, 32a, 32b, 33a, 33b, 34a, 34b, 35a) mit dem mindestens einen gekrümmten Teil (2a, 2b, 2c, 2d, 2e) der peripheren Kante der flachen Oberfläche (2) übereinstimmt, **dadurch gekennzeichnet, dass** die Photovoltaikzellen (3) Geometrien aufweisen, die untereinander verschieden sind, und jeweils einen jeweiligen Abschnitt (31-35) der mindestens teilweise gekrümmten Form der flachen Oberfläche (2) ausmachen, um die flache Oberfläche (2) zu bedecken, wobei die Abschnitte (31-35) Breiten (E1-E5) haben, die untereinander so verschieden sind, dass sie eine identische Intensität (I1) bereitstellen.

2. Vorrichtung (100, 200, 300) nach Anspruch 1, wobei die flache Oberfläche (2) des Trägers (1) eine Form hat, die aus einem Kreis, einer Ellipse, einer Niere, einem Halbmond oder einem Sektor ausgewählt ist.

3. Vorrichtung (100, 200, 300) nach einem der Ansprüche 1 oder 2, wobei mindestens ein Loch (6) zur Aufnahme eines elektrischen Bauteils an mindestens einer der Photovoltaikzellen (3) ausgeführt ist.

4. Vorrichtung (100, 200, 300) nach einem der Ansprüche 1 bis 3, die eine einzelne Gruppe von Photovoltaikzellen (4) umfasst.

5. Vorrichtung (100, 200, 300) nach einem der Ansprüche 1 bis 3, die mehrere Gruppen von Photovoltaikzellen (4) umfasst, die zueinander parallel und/oder in Reihe geschaltet sind.

6. Vorrichtung (100) nach einem der Ansprüche 1 bis 5, die ein Beleuchtungskörper ist.

7. Vorrichtung (100) nach Anspruch 6 in Verbindung mit Anspruch 3, wobei der Beleuchtungskörper zum Ausleuchten nach oben ausgelegt ist, wobei der Beleuchtungskörper mindestens eine Lampe umfasst, die in dem mindestens einen Loch (6) positioniert ist, das an mindestens einer der Photovoltaikzellen (3) ausgeführt ist.

8. Vorrichtung (200) nach einem der Ansprüche 1 bis 7, die ein Sonnenschirm ist, der ein Fußgestell (201) umfasst, das mit einem Pfosten (203) zum Tragen eines Tuchs (204) ausgestattet ist, und mindestens einen Beleuchtungskörper, der zur Ausleuchtung unter dem Tuch angeordnet ist, in ausgefahrener Position, wobei ein Träger (1), der mit mindestens einer Gruppe von Photovoltaikzellen (4) ausgestattet ist, im oberen Teil des Sonnenschirms angeordnet ist.

9. Vorrichtung nach einem der Ansprüche 1 bis 5, die ein automatisches Rasen- oder Gartenbewässerungssystem ist, das ein Magnetventil und eine Einheit zur Steuerung des Magnetventils umfasst, die elektrisch von einem Energiespeicher versorgt wird, der durch die Photovoltaikzellen (3) aufgeladenen wird.

10. Vorrichtung (300) nach einem der Ansprüche 1 bis 5, die ein Mähroboter ist, der einen Träger (1) umfasst, auf dem mindestens eine Gruppe von Photovoltaikzellen (4) angeordnet ist.

11. Vorrichtung nach einem der Ansprüche 1 bis 5, das ein Solarpanel ist.

## Claims

1. An apparatus (100, 200, 300) comprising at least one group of crystalline silicon photovoltaic cells (4) mounted in series and a support (1) defining a flat surface (2) provided with a peripheral edge of which at least part (2a, 2b, 2c, 2d, 2e) has a curved shape so as to define an at least partly curved shape for the flat surface of the support, the photovoltaic cells (3) being arranged on this flat surface (2), said cells (31, 32, 33, 34, 35) comprising a peripheral edge of which at least part (31a, 32a, 32b, 33a, 33b, 34a, 34b, 35a) matches the at least one curved part (2a, 2b, 2c, 2d, 2e) of the peripheral edge of said flat surface (2), **characterised in that** the photovoltaic cells (3) have geometries that are varied relative to each other and each constitute a respective section (31-35) of the at least partly curved shape of the flat surface (2) so as to cover said flat surface (2), the sections (31-35) being of widths (E1-E5) that are varied relative to each other so as to deliver an identical intensity (I1).

2. The apparatus (100, 200, 300) according to claim 1, wherein the flat surface (2) of the support (1) has a shape selected from a circle, an ellipse, a bean, a half-moon or a sector.

3. The apparatus (100, 200, 300) according to any one of claims 1 or 2, wherein at least one hole (6) for receiving an electrical component is implemented on at least one of the photovoltaic cells (3).

4. The apparatus (100, 200, 300) according to any one of claims 1 to 3, which comprises a single group of photovoltaic cells (4).

5. The apparatus (100, 200, 300) according to any one of claims 1 to 3, which comprises several groups of photovoltaic cells (4) connected together in parallel and/or in series.

6. The apparatus (100) according to any one of claims 1 to 5, which is a luminaire.

7. The apparatus (100) according to claim 6 attached to claim 3, wherein the luminaire is designed to illuminate upwards, said luminaire comprising at least one lamp disposed in the at least one hole (6) implemented on the at least one of the photovoltaic cells (3).

8. The apparatus (200) according to any one of claims 1 to 7, which is a parasol comprising a base (201) provided with at least one upright (203) for supporting a canvas (204) and at least one luminaire arranged to illuminate under the canvas in the deployed position, a support (1) provided with at least one group of photovoltaic cells (4) being arranged in the upper part of the parasol.

9. The apparatus according to any one of claims 1 to 5, which is an automatic lawn or garden watering system which comprises a solenoid valve and a solenoid valve control unit electrically powered by an energy accumulator recharged by means of the photovoltaic cells (3).

10. The apparatus (300) according to any one of claims 1 to 5, which is a robot lawn mower which comprises a support (1) on which the at least one group of photovoltaic cells (4) is arranged.

11. The apparatus according to any one of claims 1 to 5, which is a solar panel.
